# EUROPÄISCHE PATENTSCHRIFT

(11) **EP 3 996 894 B1**
(45) Veröffentlichungstag und Bekanntmachung des Hinweises auf die Patenterteilung: **18.01.2023**
(21) Anmeldenummer: 20735092.7
(22) Anmeldetag: 18.06.2020
(51) Int. Cl.: B29C 45/14, B29C 45/26, B29C 45/00, H05K 7/14, H01R 12/52, H01R 12/58, H01R 13/41, H01R 43/18, H01R 43/24, B29L 31/34

(54) **GEHÄUSE EINES ELEKTRONIKMODULS UND DESSEN HERSTELLUNG**
ELECTRONIC MODULE HOUSING AND PRODUCTION THEREOF
BOÎTIER D'UN MODULE ÉLECTRONIQUE ET SA FABRICATION

(30) Priorität: 30.09.2019 EP 19200557
(43) Veröffentlichungstag der Anmeldung: 18.05.2022
(73) Patentinhaber: Siemens Aktiengesellschaft, 80333 München (DE)
(72) Erfinder: NÖTH, Christoph, 90491 Nürnberg (DE); MÜNZINGER, Marius, 90459 Nürnberg (DE)
(86) Internationale Anmeldenummer: PCT/EP2020/066844
(87) Internationale Veröffentlichungsnummer: WO 2021/063551

(56) Entgegenhaltungen:
- EP-A1- 1 634 687
- DE-A1-102007 012 818
- DE-A1-102008 037 165
- US-B1- 7 494 389

## Beschreibung

Die Erfindung betrifft ein Gehäuse eines Elektronikmoduls und insbesondere ein Verfahren zum Herstellen eines Gehäuses eines Elektronikmoduls. Stand der Technik auf diesem Gebiet bildet DE10 2008 037 165, DE 10 2007 012 818 und EP 1 634 687.

In der Leistungselektronik werden immer häufiger an spezielle Anwendungen angepasste Elektronikmodule benötigt. Derartige Elektronikmodule werden in der Regel in Kleinserien gefertigt, wodurch ihre Herstellung aufwändiger und kostspieliger als die Herstellung von Elektronikmodulen in Großserien mit hohen Stückzahlen ist. Insbesondere betrifft dies Gehäuse von Elektronikmodulen mit speziellen Terminalbestückungen.

Gehäuse von Elektronikmodulen werden beispielsweise durch Spritzgießen hergestellt, wobei die Terminals mit Kunststoff umspritzt werden. Ein Vorteil dieses Herstellungsverfahrens ist die "Bondbarkeit" der Terminals, welche beim Bondprozess nicht in Eigenschwingung versetzt werden können, so das Bondergebnis unkontrollierbar machen und wegen des Wegfalls von alternativen Fügeprozessen zum Zusammenfügen des Gehäuses nicht durch derartige Fügeprozesse beschädigt oder verschmutzt werden können. Nachteilig ist jedoch, dass dabei für jede Anordnung der Terminals ein spezielles Spritzgießwerkzeug benötigt wird, welches den Positionen der Terminals angepasst ist.

Bei einem anderen Verfahren zum Herstellen von Gehäusen von Elektronikmodulen werden die Terminals in einen zuvor gefertigten Kunststoffrahmen mit relativ hoher Geschwindigkeit und Kraft eingedrückt. Durch die dabei eingebrachte Reibung schmilzt der Kunststoffrahmen selektiv auf und verschweißt die Terminals fest an ihren Positionen, oder das Material des Kunststoffrahmens gibt ausreichend nach und verklemmt die Terminals. Ein Vorteil dieses Verfahrens ist die Varianzvielfalt der Terminalbestückung. Selbst wenn der Kunststoffrahmen schon längere Zeit existiert, können die Terminals unterschiedlich angeordnet werden. Nachteilig ist jedoch, dass unterhalb von Bondpads keine stoffschlüssige Verbindung besteht. Es kann nur zuverlässig auf einem Bondpad gebondet werden, wenn ein Terminal das Bondpad sicher und definiert an den Kunststoffrahmen drückt. Das eingeschränkte Prozessfenster sowie die erforderliche hohe mechanische Abstimmung steigern die Fehleranfälligkeit. Außerdem kann bei diesem Verfahren nicht jeder Kunststoff verwendet werden, da beispielsweise hochgefüllte Kunststoffe eher brechen als selektiv aufzuschmelzen oder sich zu verformen.

Bei einem weiteren Verfahren werden zunächst ein innerer und ein äußerer Rahmen als separate Kunststoffspritzgießteile hergestellt. Beim Zusammenbau des Gehäuses werden zunächst die gewünschten Terminals in den größeren, äußeren Rahmen gesteckt. Danach wird unterhalb jedes Bondpads Kleber aufgebracht und alle Gehäuseteile werden miteinander verklebt. Vorteile dieses Verfahrens sind die hohe Robustheit im Herstellungsprozess und die variable Terminalpositionierung. Nachteile sind die langen Prozesszeiten und die Kosten für ein zweites Kunststoffbauteil.

Der Erfindung liegt die Aufgabe zugrunde, ein verbessertes Verfahren zum Herstellen eines Gehäuses eines Elektronikmoduls anzugeben.

Die Aufgabe wird erfindungsgemäß durch ein Verfahren mit den Merkmalen des Anspruchs 1 gelöst.

Vorteilhafte Ausgestaltungen der Erfindung sind Gegenstand der abhängigen Ansprüche.

Bei dem erfindungsgemäßen Verfahren zum Herstellen eines Gehäuses eines Elektronikmoduls werden Leads, die jeweils eine bondbare Leadoberfläche aufweisen, in einem Spritzgießwerkzeug mit einem Kunststoff umspritzt, wobei für jedes Lead eine Pinausnehmung erzeugt wird, die durch den Kunststoff verläuft und eine Leadausnehmung in dem Lead umfasst, und wobei ein wenigstens Teil jeder bondbaren Leadoberfläche nicht bespritzt wird. In wenigstens eine Pinausnehmung wird ein elektrisch leitfähiges Pinelement eingesetzt, wobei das Pinelement durch die Leadausnehmung der Pinausnehmung geführt wird.

Die Erfindung ermöglicht eine individuelle Bestückung der Pinausnehmungen des Gehäuses mit Pinelementen, wobei ein die die Leads und Pinausnehmungen aufweisender Gehäuserahmen des Gehäuses als ein Serienprodukt hergestellt werden kann. Dadurch werden die Vorteile einer Serienproduktion des Gehäuserahmens mit einer der jeweiligen Anwendung anpassbaren Pinbestückung kombiniert. Durch das Umspritzen der Leads in dem Spritzgießwerkzeug wird überdies eine prozesssichere Bondbarkeit der Leads ermöglicht. Gegenüber einem Eindrücken von Terminals in einen Gehäuserahmen bietet das Verfahren den Vorteil, dass kein spezieller Kunststoff, der ein Brechen des Gehäuses beim Eindrücken der Terminals verhindert, zum Fertigen des Gehäuses erforderlich ist.

Bei einer Ausgestaltung der Erfindung wird jedes Pinelement beim Einsetzen in eine Pinausnehmung formschlüssig mit dem Lead verbunden. Beispielsweise weist jedes Pinelement einen Verengungsabschnitt auf, der bezüglich seines Querschnitts und seiner Ausdehnung zu einer Leadausnehmung korrespondiert und an den sich beidseitig jeweils ein Anschlagabschnitt des Pinelements anschließt, dessen Querschnitt größer als ein Querschnitt einer Leadausnehmung ist. Die formschlüssige Verbindung eines Pinelements mit einem Lead wird dabei hergestellt, indem ein erster Anschlagabschnitt des Pinelements durch die Leadausnehmung des Lead gedrückt wird bis der zweite Anschlagabschnitt des Pinelements an dem Lead anschlägt. Eine derartige formschlüssige Verbindbarkeit der Pinelemente mit jeweils einem Lead ermöglicht vorteilhaft eine zuverlässige und variable Pinbestückung des Gehäuses. Um das Einführen und Durchführen eines Pinelements in eine Leadausnehmung zu erleichtern, kann jedes Pinelement einen Endabschnitt aufweisen, der sich mit abnehmender Querschnittsfläche von dem ersten Anschlagabschnitt weg erstreckt, beispielsweise einen konusförmigen, insbesondere einen kegelförmigen, Endabschnitt.

Bei einer weiteren Ausgestaltung der Erfindung weist das Spritzgießwerkzeug für jede zu erzeugende Pinausnehmung eine Stempelkomponente und eine Matrizenkomponente auf, die bei einem Schließen des Spritzgießwerkzeugs die Leadausnehmung der Pinausnehmung auf einander gegenüberliegenden Seiten verschließen und nach dem Schließen des Spritzgießwerkzeugs mit dem Kunststoff umspritzt werden. Dabei kann vorgesehen sein, dass die Leadausnehmungen beim Schließen des Spritzgießwerkzeugs durch Drücken der Stempelkomponenten in die Leads erzeugt oder vergrößert werden. Insbesondere kann jede Stempelkomponente ein spitz zulaufendes Stempelende aufweisen, das zum Erzeugen oder Vergrößern einer Leadausnehmung in ein Lead gedrückt wird. Ferner kann jede Matrizenkomponente ein Matrizenende aufweisen, das eine Vertiefung aufweist, die von einer ringförmigen Wandung berandet ist, die nach dem Schließen des Spritzgießwerkzeugs an dem Lead anliegt und die Leadausnehmung an einer Seite verschließt. Dadurch können die Leadausnehmungen vorteilhaft während des Schließens des Spritzgießwerkzeugs erzeugt oder endgefertigt und gleichzeitig gegen ein Eindringen von Kunststoff während des anschließenden Spritzgießens geschützt werden. Die Vertiefung in dem Matrizenende einer Matrizenkomponente ermöglicht vorteilhaft ein Verformen des Lead in die Vertiefung hinein, wenn das Stempelende der Stempelkomponente in das Lead gedrückt wird.

Bei einer weiteren Ausgestaltung der Erfindung weist jedes Pinelement wenigstens einen Verdickungsabschnitt auf, der einen gegenüber an ihn grenzenden Bereichen des Pinelements vergrößerten Durchmesser aufweist, der zu einem Durchmesser einer Pinausnehmung außerhalb der Leadausnehmung korrespondiert. Dadurch werden die Pinelemente vorteilhaft in den Pinausnehmungen stabilisiert.

Bei einer weiteren Ausgestaltung der Erfindung ist jedes Pinelement derart gestaltet, dass ein Kontaktierungsende des Pinelements nach dem Einsetzen in eine Pinausnehmung aus der Pinausnehmung herausragt. Dadurch können die Pinelemente einfach von außen kontaktiert werden.

Bei einer weiteren Ausgestaltung der Erfindung werden die Pinelemente vor dem Einsetzen in Pinausnehmungen an einer Leiterplatte angeordnet und gleichzeitig in Pinausnehmungen eingesetzt. Auf diese Weise brauchen die Pinelemente nicht einzeln in Pinausnehmungen eingesetzt und nachträglich aufwändig mit einer Leiterplatte verbunden werden. Ferner kann vorgesehen sein, dass das Gehäuse mit wenigstens einem Befestigungselement, beispielsweise mit einer Gewindeausnehmung, einem Schapphaken und/oder einer Rastnase, gefertigt wird, das zum Befestigen der Leiterplatte an dem Gehäuse ausgebildet ist. Wenn die Leiterplatte an dem Gehäuse befestigbar ist, kann die oben beschriebene formschlüssige Verbindung der Pinelemente mit den Leads entfallen, da die Pinelemente durch die Leiterplatte in ihrer Position gehalten werden, wodurch die Leiterplatte mit der Pinbestückung austauschbar wird.

Bei einer weiteren Ausgestaltung der Erfindung werden die Leads in Form eines Leadframe mit einem Leadhalter, an dem die Leads angeordnet sind, hergestellt und der Leadhalter wird nach dem Umspritzen der Leads von den Leads getrennt und entfernt. Dadurch wird das Einlegen der Leads in das Spritzgießwerkzeug erleichtert. Das Leadframe kann beispielsweise mit Sollbruchstellen zum Trennen des Leadhalters von den Leads gefertigt werden. Dadurch wird das Trennen des Leadhalters von den Leads vorteilhaft erleichtert.

Ein erfindungsgemäßes Gehäuse ist mit dem erfindungsgemäßen Verfahren hergestellt. Ein erfindungsgemäßes Elektronikmodul weist ein Gehäuse auf, das mit dem erfindungsgemäßen Verfahren hergestellt ist. Die Vorteile eines erfindungsgemäßen Gehäuses und eines erfindungsgemäßen Elektronikmoduls entsprechen den oben genannten Vorteilen des erfindungsgemäßen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Leadframe und Pinausnehmungen in einer perspektivischen Darstellung,
FIG 2 das Leadframe, einen Abschnitt eines Gehäuserahmens sowie Stempelkomponenten und Matrizenkomponenten eines Spritzgießwerkzeugs in einer perspektivischen Darstellung,
FIG 3 Leads und einen Abschnitt des Gehäuserahmens nach dem Spritzgießen und Abtrennen und Entfernen des Leadhalters des Leadframe in einer perspektivischen Darstellung,
FIG 4 ein Lead, ein Stempelende einer Stempelkomponente und ein Matrizenende einer Matrizenkomponente in einer ersten Stellung bei dem Schließen des Spritzgießwerkzeugs vor dem Spritzgießen in einer perspektivischen und teilweise geschnittenen Darstellung,
FIG 5 das Lead, das Stempelende und das Matrizenende in einer zweiten Stellung bei dem Schließen des Spritzgießwerkzeugs vor dem Spritzgießen in einer zu Figur 3 analogen Darstellung,
FIG 6 das Lead, das Stempelende und das Matrizenende in einer Stellung während des Spritzgießens in einer zu Figur 3 analogen Darstellung,
FIG 7 das Lead, das Stempelende und das Matrizenende in einer Stellung bei dem Öffnen des Spritzgießwerkzeugs nach dem Spritzgießen in einer zu Figur 3 analogen Darstellung,
FIG 8 einen Abschnitt eines Gehäuses eines Elektronikmoduls in einer perspektivischen Darstellung,
FIG 9 einen Abschnitt eines Gehäuses eines Elektronikmoduls in einer Schnittdarstellung,
FIG 10 ein leadseitiges Ende eines Pinelements und ein Lead in einer ersten Stellung beim Einsetzen des Pinelements in eine Pinausnehmung in einer perspektivischen und teilweise geschnittenen Darstellung,
FIG 11 das leadseitige Ende eines Pinelements und ein Lead nach dem Einsetzen des Pinelements in eine Pinausnehmung in einer perspektivischen und teilweise geschnittenen Darstellung,
FIG 12 ein Elektronikmodul mit einem Gehäuse und einer Leiterplatte vor dem Montieren der Leiterplatte an einem Gehäuserahmen des Gehäuses in einer perspektivischen Darstellung.

Einander entsprechende Teile sind in den Figuren mit denselben Bezugszeichen versehen.

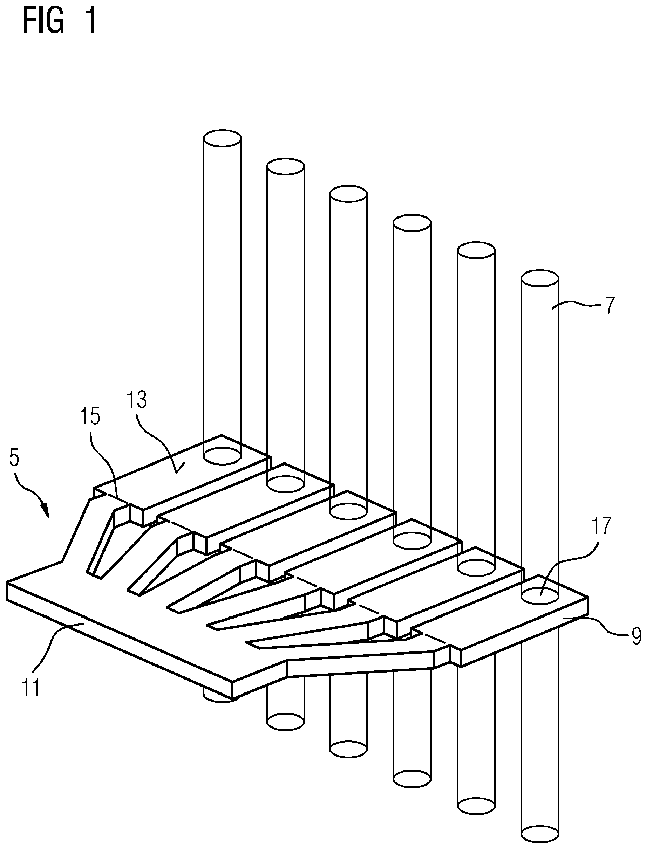

Die Figuren 1 bis 11 zeigen Komponenten eines Gehäuses 1 eines Elektronikmoduls 3 in verschiedenen Stadien der Herstellung des Gehäuses 1 gemäß einem Ausführungsbeispiel des erfindungsgemäßen Verfahrens zum Herstellen des Gehäuses 1.

Figur 1 (FIG 1) zeigt ein Leadframe 5 und Pinausnehmungen 7 in einer perspektivischen Darstellung. Das Leadframe 5 umfasst mehrere voneinander beabstandete Leads 9 und einen Leadhalter 11, an dem die Leads 9 angeordnet sind. Jedes Lead 9 ist beispielsweise aus Kupfer mit einer vernickelten bondbaren Leadoberfläche 13 gefertigt. Das Leadframe 5 weist für jedes Lead 9 eine Sollbruchstelle 15 zum Abtrennen des Leadhalters 11 von den Leads 9 auf. Jedes Lead 9 weist eine Leadausnehmung 17 auf, die Teil einer Pinausnehmung 7 ist, die durch einen Gehäuserahmen 19 des Gehäuses 1 verläuft. Der Gehäuserahmen 19 wird aus Kunststoff durch Spritzgießen in einem Spritzgießwerkzeug 20 gefertigt.

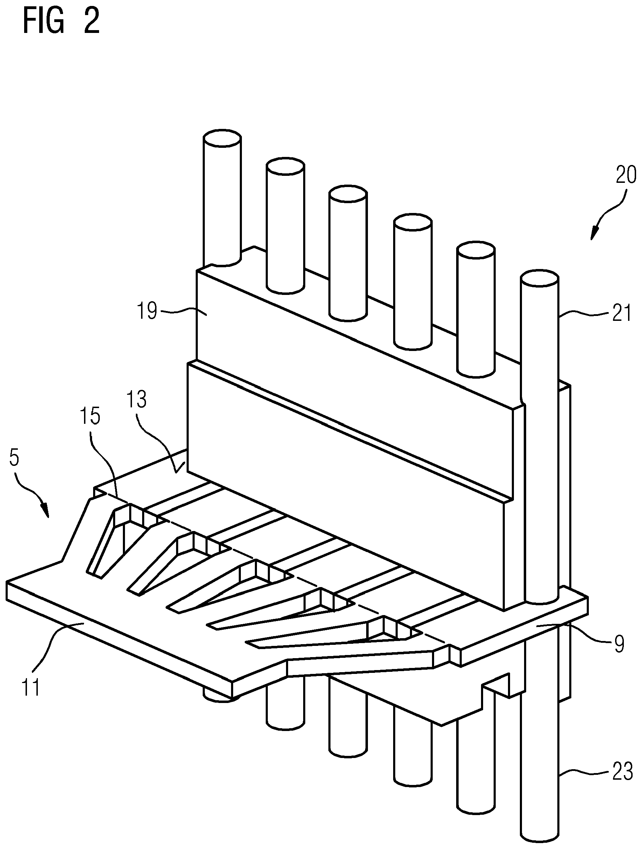

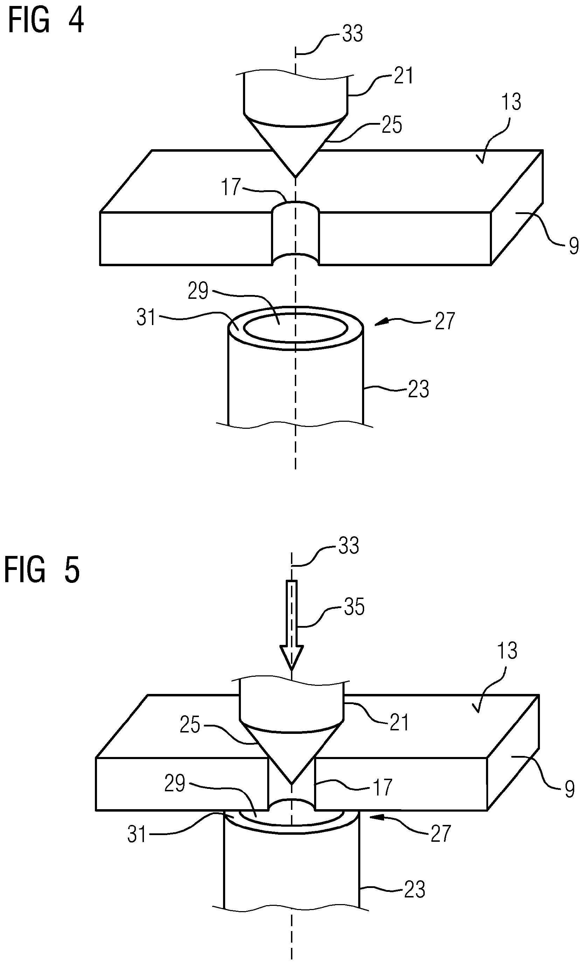

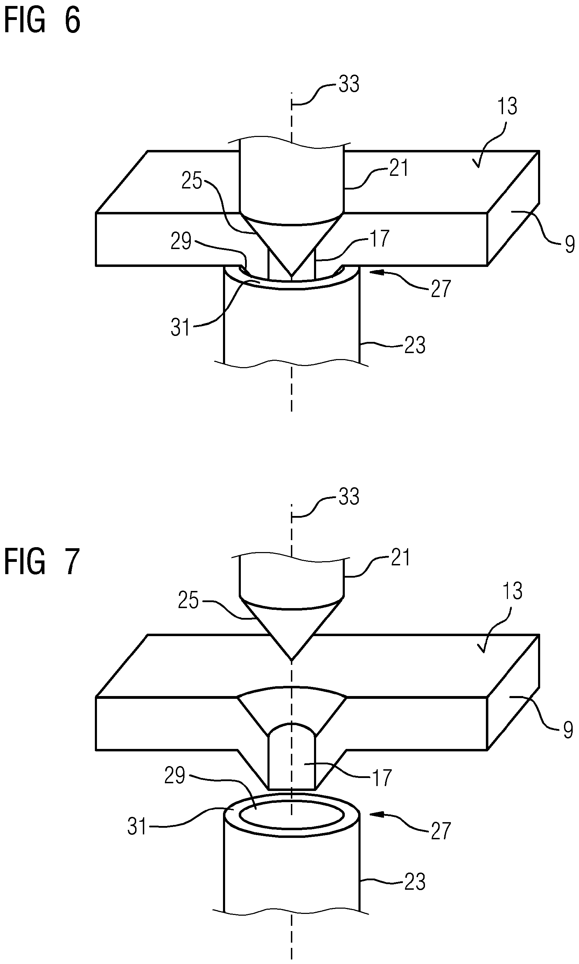

Figur 2 (FIG 2) zeigt das Leadframe 5, einen Abschnitt des Gehäuserahmens 19 sowie Stempelkomponenten 21 und Matrizenkomponenten 23 des Spritzgießwerkzeugs 20 in einer perspektivischen Darstellung. Weitere Komponenten des Spritzgießwerkzeugs 20 sind der Übersichtlichkeit halber nicht dargestellt und konventionell ausgeführt. Zur Herstellung des Gehäuserahmens 19 wird das Leadframe 5 in das Spritzgießwerkzeug 20 eingelegt. Das Spritzgießwerkzeug 20 wird geschlossen, wobei jede Leadausnehmung 17 durch eine Stempelkomponente 21 und eine Matrizenkomponente 23 vergrößert und verschlossen wird, siehe dazu die Figuren 5 und 6. Nach dem Schließen des Spritzgießwerkzeugs 20 werden die Leads 9, die Stempelkomponenten 21 und die Matrizenkomponenten 23 mit dem Kunststoff umspritzt, wobei die Zwischenräume zwischen den Leads 9 mit dem Kunststoff gefüllt werden und ein Teil jeder Leadoberfläche 13 nicht bespritzt wird, um auf diesem Teil ein späteres Bonden zu ermöglichen. Nach dem Spritzgießen wird das Spritzgießwerkzeug 20 geöffnet und der Leadhalter 11 wird an den Sollbruchstellen 15 von den Leads 9 getrennt und entfernt.

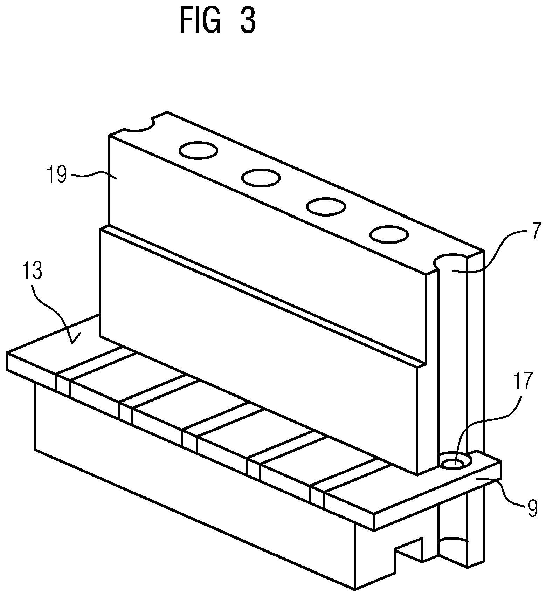

Figur 3 (FIG 3) zeigt Leads 9 und einen Abschnitt des Gehäuserahmens 19 nach dem Spritzgießen und Abtrennen und Entfernen des Leadhalters 11 in einer perspektivischen Darstellung.

Die Figuren 4 bis 7 (FIG 4 bis FIG 7) zeigen das Vergrößern und Verschließen einer Leadausnehmung 17 eines Lead 9 durch eine Stempelkomponente 21 und eine Matrizenkomponente 23 in perspektivischen Darstellungen, in denen das Lead 9 jeweils geschnitten dargestellt ist.

Figur 4 (FIG 4) zeigt das Lead 9, ein Stempelende 25 der Stempelkomponente 21 und ein Matrizenende 27 der Matrizenkomponente 23 bei dem Schließen des Spritzgießwerkzeugs 20 in einer ersten Stellung, während das Stempelende 25 und das Matrizenende 27 auf sich gegenüberliegenden Seiten des Lead 9 an die vorgefertigte Leadausnehmung 17 des Lead 9 herangefahren werden. Das Stempelende 25 ist kegelförmig mit einer in die Leadausnehmung 17 einfahrenden Spitze ausgebildet. Das Matrizenende 27 weist eine Vertiefung 29 auf, die von einer ringförmigen Wandung 31 berandet ist und einen größeren Querschnitt als die Leadausnehmung 17 aufweist. Abgesehen von dem Stempelende 25 und dem Matrizenende 27 sind die Stempelkomponente 21 und die Matrizenkomponente 23 kreiszylindrisch ausgebildet und entlang einer gemeinsamen Zylinderachse 33 ausgerichtet, die durch die Leadausnehmung 17 verläuft und entlang derer die Stempelkomponente 21 und die Matrizenkomponente 23 beim Schließen und Öffnen des Spritzgießwerkzeugs 20 bewegt werden.

Figur 5 (FIG 5) zeigt das Lead 9, das Stempelende 25 und das Matrizenende 27 bei dem Schließen des Spritzgießwerkzeugs 20 in einer zweiten Stellung, in der das Stempelende 25 und die Wandung 31 des Matrizenendes 27 auf sich gegenüberliegenden Seiten an dem Lead 9 anliegen. Nachfolgend wird eine Kraft mit einer Kraftrichtung 35 auf die Stempelkomponente 21 ausgeübt, wodurch das Stempelende 25 entlang der Zylinderachse 33 in das Lead 9 gedrückt wird, so dass die Leadausnehmung 17 vergrößert wird und das Lead 9 im Bereich der Leadausnehmung 17 in die Vertiefung 29 des Matrizenendes 27 hinein verformt wird.

Figur 6 (FIG 6) zeigt das verformte Lead 9, das Stempelende 25 und das Matrizenende 27 in einer Stellung während des Spritzgießens, in der die Leadausnehmung 17 von dem Stempelende 25 und dem Matrizenende 27 verschlossen wird.

Figur 7 (FIG 7) zeigt das verformte Lead 9, das Stempelende 25 und das Matrizenende 27 in einer Stellung bei dem Öffnen des Spritzgießwerkzeugs 20 nach dem Spritzgießen, bei dem die Stempelkomponente 21 und die Matrizenkomponente 23 entlang der Zylinderachse 33 in einander entgegengesetzten Richtungen von dem Lead 9 wegbewegt werden (der eingespritzte Kunststoff ist nicht dargestellt).

Bei dem in den Figuren 4 bis 7 gezeigten Ausführungsbeispiel werden die Leadausnehmungen 17 der Leads 9 bereits bei der Fertigung des Leadframe 5 vorgefertigt und bei dem Schließen des Spritzgießwerkzeugs 20 wie beschrieben vergrößert und verschlossen. In einem anderen Ausführungsbeispiel werden die Leadausnehmungen 17 durch das Eindrücken der Stempelenden 25 in die Leads 9 bei dem Schließen des Spritzgießwerkzeugs 20 erst erzeugt. Bei einem weiteren Ausführungsbeispiel werden die Leadausnehmungen 17 bei der Fertigung des Leadframe 5 vollständig vorgefertigt und bei dem Schließen des Spritzgießwerkzeugs 20 jeweils durch eine Stempelkomponente 21 und eine Matrizenkomponente 23 lediglich verschlossen.

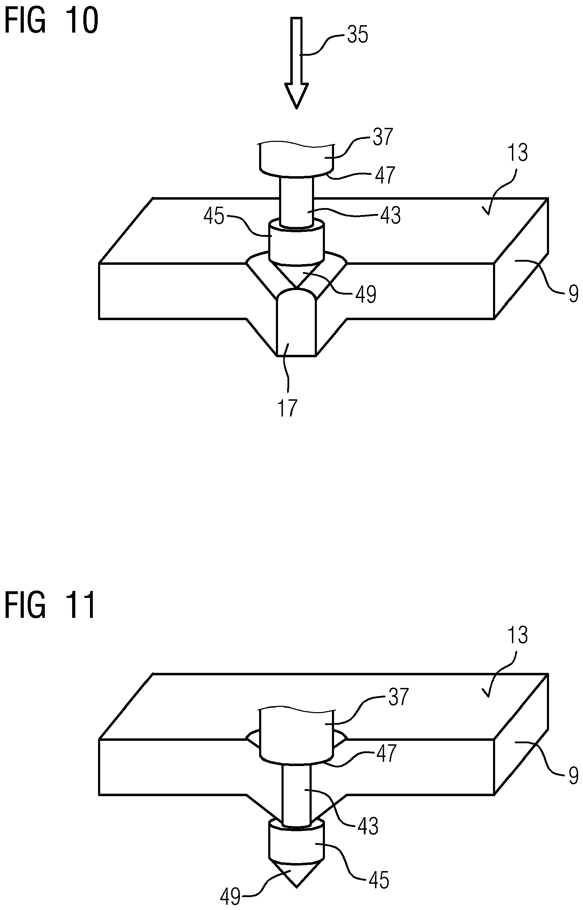

Nach dem Spritzgießen werden Pinelemente 37 in Pinausnehmungen 7 eingesetzt, wobei sie jeweils formschlüssig an der Leadausnehmung 17 eines Lead 9 verankert werden (siehe dazu die Figuren 10 und 11).

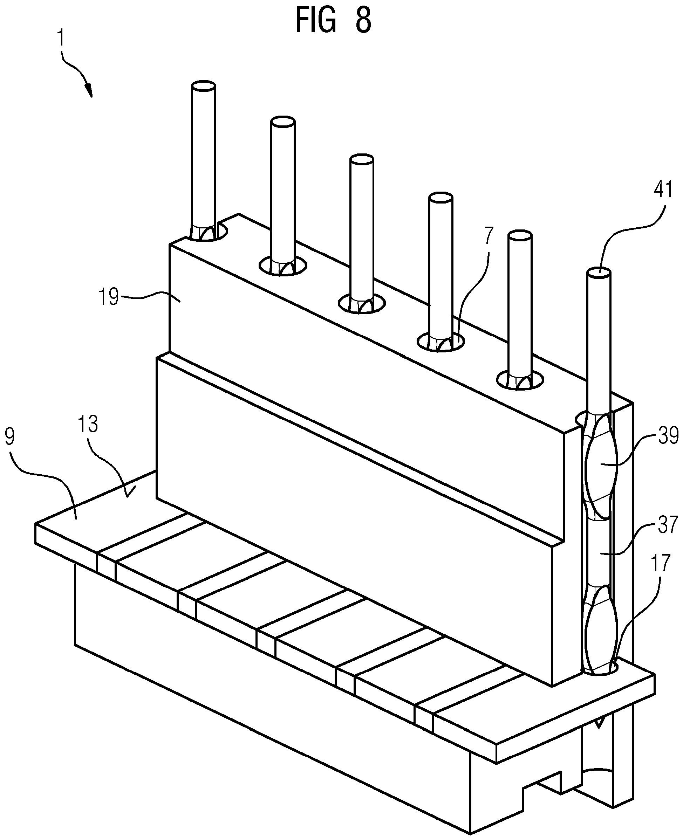

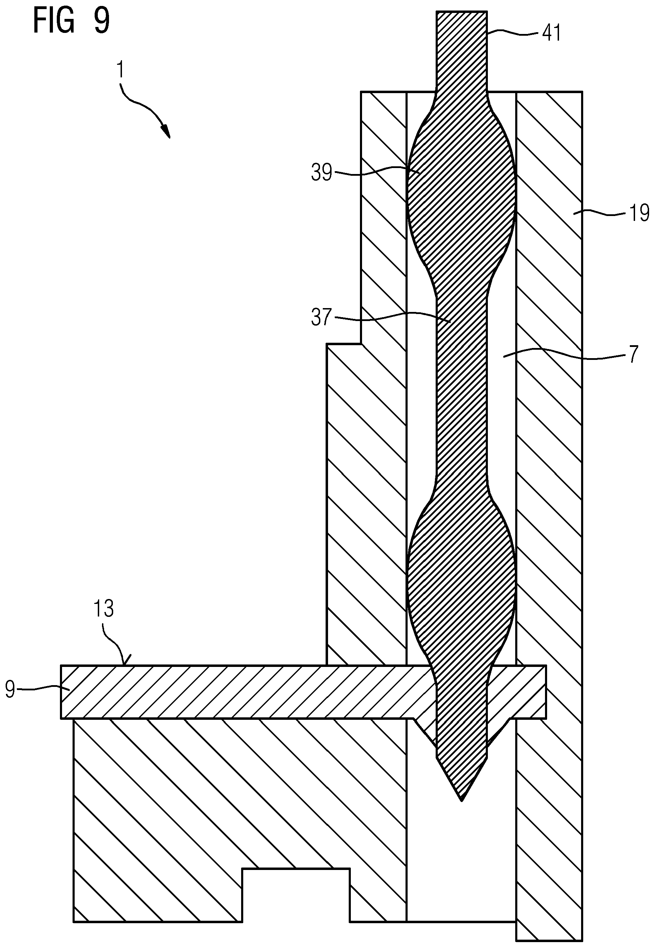

Figur 8 (FIG 8) und Figur 9 (FIG 9) zeigen das Gehäuse 1 nach dem Einsetzen der Pinelemente 37 in Pinausnehmungen 7. Dabei zeigt Figur 8 eine perspektivische Darstellung eines Abschnitts des Gehäuses 1 und Figur 9 zeigt eine Schnittdarstellung des Gehäuses 1. Jedes Pinelement 37 weist zwei Verdickungsabschnitte 39 auf, die jeweils einen gegenüber an sie grenzenden Bereichen des Pinelements 37 vergrößerten Durchmesser aufweisen, der zu einem Durchmesser der Pinausnehmungen 7 außerhalb der Leadausnehmung 17 korrespondiert. Durch die Verdickungsabschnitte 39 werden die Pinelemente 37 in den Pinausnehmungen 7 stabilisiert. Ein Kontaktierungsende 41 jedes Pinelements 37 ragt nach dem Einsetzen in eine Pinausnehmung 7 aus der Pinausnehmung 7 heraus.

Figur 10 (FIG 10) und Figur 11 (FIG 11) zeigen das leadseitige Ende eines Pinelements 37 und ein Lead 9 beim Einsetzen des Pinelements 37 in eine Pinausnehmung 17 in einer perspektivischen Darstellung, wobei das Lead 9 geschnitten dargestellt ist. Das leadseitige Ende des Pinelements 37 weist einen Verengungsabschnitt 43 auf, der bezüglich seines Querschnitts und seiner Ausdehnung zu der Leadausnehmung 17 korrespondiert und an den sich beidseitig jeweils ein Anschlagabschnitt 45, 47 anschließt, dessen Querschnitt größer als der Querschnitt der Leadausnehmung 17 ist. Die formschlüssige Verbindung des Pinelements 37 mit dem Lead 9 wird hergestellt, indem ein erster Anschlagabschnitt 45 des Pinelements 37 in der Kraftrichtung 35 durch die Leadausnehmung 17 gedrückt wird bis der zweite Anschlagabschnitt 47 des Pinelements 37 an dem Lead 9 anschlägt. Das Pinelement 37 weist einen kegelförmigen Endabschnitt 49 auf, der sich mit abnehmender Querschnittsfläche von dem ersten Anschlagabschnitt 45 weg erstreckt und das Drücken des Pinelements 37 in die Leadausnehmung 17 erleichtert. Figur 10 zeigt das Pinelement 37 in einer Stellung vor dem Verbinden mit dem Lead 9. Figur 11 zeigt das Pinelement 37 nach dem Verbinden mit dem Lead 9. Die Anschlagabschnitte 45, 47 wirken als Widerhaken, die ein Lösen der Verbindung des Pinelements 37 mit dem Lead 9 verhindern.

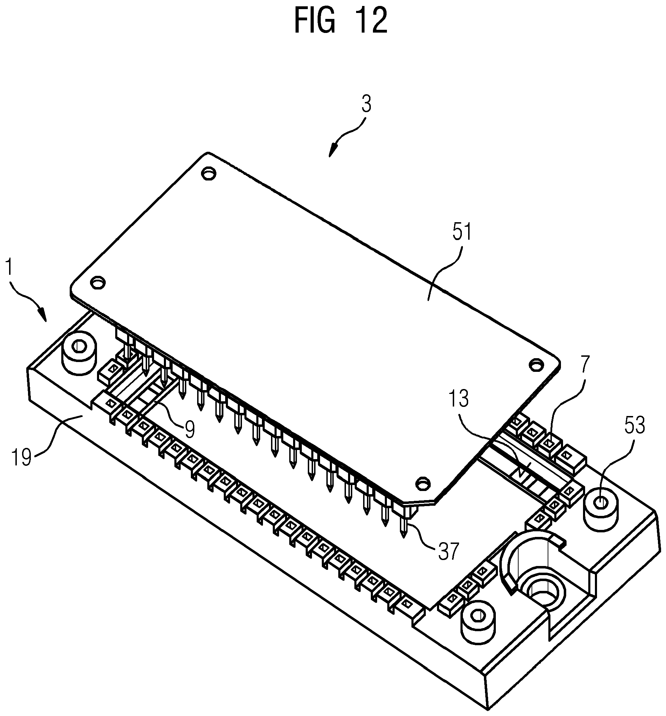

Figur 12 (FIG 12) zeigt ein Ausführungsbeispiel eines Elektronikmoduls 3 mit einem Gehäuse 1 und einer Leiterplatte 51 vor dem Montieren der Leiterplatte 51 an einer Oberseite des Gehäuserahmens 19 des Gehäuses 1 in einer perspektivischen Darstellung. Das Gehäuse 1 ist mit einem anhand der Figuren 1 bis 11 beschriebenen Verfahren hergestellt, wobei die Pinelemente 37 vor dem Einsetzen in Pinausnehmungen 7 an der Leiterplatte 51 angeordnet werden (beispielsweise durch Verlöten) und gleichzeitig in Pinausnehmungen 7 des Gehäuserahmens 19 eingesetzt werden. Der Gehäuserahmen 19 wird mit Gewindeausnehmungen 53 gefertigt, die zum Verschrauben des Gehäuserahmens 19 mit der Leiterplatte 51 ausgebildet sind. Das Elektronikmodul 3 kann weitere (nicht dargestellte) Komponenten aufweisen, beispielsweise eine Bodenplatte, die an einer Unterseite des Gehäuserahmens 19 angeordnet ist, und/oder einen unterhalb des Gehäuserahmens 19 angeordneten Kühlkörper. Ferner weist das Elektronikmodul 3 auf der Leiterplatte 51, der Bodenplatte und/oder dem Kühlkörper angeordnete elektrische Bauelemente auf, die ebenfalls nicht dargestellt sind. Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen wie in den Ansprüchen definiert.

## Patentansprüche

1. Verfahren zum Herstellen eines Gehäuses (1) eines Elektronikmoduls (3), wobei
- Leads (9), die jeweils eine bondbare Leadoberfläche (13) aufweisen, in einem Spritzgießwerkzeug (20) mit einem Kunststoff umspritzt werden, wobei für jedes Lead (9) eine Pinausnehmung (7) erzeugt wird, die durch den Kunststoff verläuft und eine Leadausnehmung (17) in dem Lead (9) umfasst, und wobei wenigstens ein Teil jeder bondbaren Leadoberfläche (13) nicht bespritzt wird, und
- in wenigstens eine Pinausnehmung (7) ein elektrisch leitfähiges Pinelement (37) eingesetzt wird, wobei das Pinelement (37) durch die Leadausnehmung (17) der Pinausnehmung (7) geführt wird,
**dadurch gekennzeichnet, dass** das Spritzgießwerkzeug (20) für jede zu erzeugende Pinausnehmung (7) eine Stempelkomponente (21) und eine Matrizenkomponente (23) aufweist, die bei einem Schließen des Spritzgießwerkzeugs (20) die Leadausnehmung (17) der Pinausnehmung (7) auf einander gegenüberliegenden Seiten verschließen und nach dem Schließen des Spritzgießwerkzeugs (20) mit dem Kunststoff umspritzt werden.

2. Verfahren nach Anspruch 1,
wobei jedes Pinelement (37) beim Einsetzen in eine Pinausnehmung (7) formschlüssig mit dem Lead (9) verbunden wird.

3. Verfahren nach Anspruch 2,
wobei jedes Pinelement (37) einen Verengungsabschnitt (43) aufweist, der bezüglich seines Querschnitts und seiner Ausdehnung zu einer Leadausnehmung (17) korrespondiert und an den sich beidseitig jeweils ein Anschlagabschnitt (45,47) des Pinelements (37) anschließt, dessen Querschnitt größer als ein Querschnitt einer Leadausnehmung (17) ist, und wobei die formschlüssige Verbindung eines Pinelements (37) mit einem Lead (9) hergestellt wird, indem ein erster Anschlagabschnitt (45) des Pinelements (37) durch die Leadausnehmung (17) des Lead (9) gedrückt wird bis der zweite Anschlagabschnitt (47) des Pinelements (37) an dem Lead (9) anschlägt.

4. Verfahren nach einem der vorhergehenden Ansprüche,
wobei jedes Pinelement (37) einen Endabschnitt (49) aufweist, der sich mit abnehmender Querschnittsfläche von dem ersten Anschlagabschnitt (45) weg erstreckt.

5. Verfahren nach einem der vorhergehenden Ansprüche,
wobei die Leadausnehmungen (17) beim Schließen des Spritzgießwerkzeugs (20) durch Drücken der Stempelkomponenten (21) in die Leads (9) erzeugt oder vergrößert werden.

6. Verfahren nach einem der vorhergehenden Ansprüche,
wobei jede Stempelkomponente (21) ein spitz zulaufendes Stempelende (25) aufweist, das zum Erzeugen oder Vergrößern einer Leadausnehmung (17) in ein Lead (9) gedrückt wird.

7. Verfahren nach einem der vorhergehenden Ansprüche,
wobei jede Matrizenkomponente (23) ein Matrizenende (27) aufweist, das eine Vertiefung (29) aufweist, die von einer ringförmigen Wandung (31) berandet ist, die nach dem Schließen des Spritzgießwerkzeugs (20) an dem Lead (9) anliegt und die Leadausnehmung (17) an einer Seite verschließt.

8. Verfahren nach einem der vorhergehenden Ansprüche,
wobei jedes Pinelement (37) wenigstens einen Verdickungsabschnitt (39) aufweist, der einen gegenüber an ihn grenzenden Bereichen des Pinelements (37) vergrößerten Durchmesser aufweist, der zu einem Durchmesser einer Pinausnehmung (7) außerhalb der Leadausnehmung (17) korrespondiert.

9. Verfahren nach einem der vorhergehenden Ansprüche,
wobei jedes Pinelement (37) derart gestaltet ist, dass ein Kontaktierungsende (41) des Pinelements (37) nach dem Einsetzen in eine Pinausnehmung (7) aus der Pinausnehmung (7) herausragt.

10. Verfahren nach einem der vorhergehenden Ansprüche,
wobei Pinelemente (37) vor dem Einsetzen in Pinausnehmungen (7) an einer Leiterplatte (51) angeordnet werden und gleichzeitig in Pinausnehmungen (7) eingesetzt werden.

11. Verfahren nach Anspruch 10,
wobei das Gehäuse (1) mit wenigstens einem Befestigungselement gefertigt wird, das zum Befestigen der Leiterplatte (51) an dem Gehäuse (1) ausgebildet ist.

12. Verfahren nach einem der vorhergehenden Ansprüche,
wobei die Leads (9) in Form eines Leadframe (5) mit einem Leadhalter (11), an dem die Leads (9) angeordnet sind, hergestellt werden und der Leadhalter (11) nach dem Umspritzen der Leads (9) von den Leads (9) getrennt und entfernt wird.

13. Gehäuse (1), das mit einem Verfahren nach einem der vorhergehenden Ansprüche hergestellt ist.

14. Elektronikmodul (3) mit einem Gehäuse (1), das mit einem Verfahren nach einem der Ansprüche 1 bis 12 hergestellt ist.

## Claims

1. Method for producing a housing (1) of an electronic module (3), wherein
- leads (9), which each have a bondable lead surface (13), are injection moulded with a plastic in a plastic injection mould (20), wherein a pin recess (7) is produced for each lead (9), which pin recess passes through the plastic and comprises a lead recess (17) in the lead (9), and wherein at least one part of each bondable lead surface (13) is not injectionmoulded, and
- an electrically conductive pin element (37) is inserted into at least one pin recess (7), wherein the pin element (37) is guided through the lead recess (17) of the pin recess (7), **characterised in that** the injection moulded tool (20) has a stamp component (21) and a matrix component (23) for each pin recess (7) to be produced, said components (21, 23) sealing the lead recess (17) of the pin recess (7) on opposing sides when the injection moulded tool (20) is closed and being injection moulded with the plastic after the injection moulded tool (20) is closed.

2. Method according to claim 1,
wherein each pin element (37) is connected in a form-fit manner with the lead (9) upon insertion into a pin recess (7).

3. Method according to claim 2,
wherein each pin element (37) has a tapering section (43), which corresponds to a lead recess (17) with respect to its cross-section and its extent and to which on both sides a stop section (45,47) of the pin element (37) adjoins in each case, the cross-section of which is larger than a cross-section of a lead recess (17), and wherein the form-fit connection of a pin element (37) is produced with a lead (9), by a first stop section (45) of the pin element (37) being pushed through the lead recess (17) of the lead (9) until the second stop section (47) of the pin element (37) abuts the lead (9).

4. Method according to one of the preceding claims,
wherein each pin element (37) has an end section (49) which extends with a reducing cross-sectional area away from the first stop section (45).

5. Method according to one of the preceding claims, wherein when the plastic injection mould (20) is closed the lead recesses (17) are produced or enlarged by pushing the stamp component (21) into the leads (9).

6. Method according to one of the preceding claims,
wherein each stamp component (21) has a tapering stamp end (25), which is pushed into a lead (9) in order to produce or enlarge a lead recess (17).

7. Method according to one of the preceding claims,
wherein each matrix component (23) has a matrix end (27), which has a depression (29), which is edged by a ring-shaped wall (31), which rests against the lead (9) after the plastic injection mould (20) is closed and seals the lead recess (17) on one side.

8. Method according to one of the preceding claims,
wherein each pin element (37) has at least one thickening section (39), which has a diameter which is enlarged compared with adjoining regions of the pin element (37), said diameter corresponding to a diameter of a pin recess (7) outside of the lead recess (17).

9. Method according to one of the preceding claims,
wherein each pin element (37) is designed so that a contacting end (41) of the pin element (37) projects from the pin recess (7) after insertion into a pin recess (7).

10. Method according to one of the preceding claims,
wherein pin elements (37) are arranged on a printed circuit board (51) before insertion into pin recesses (7) and are inserted simultaneously into pin recesses (7).

11. Method according to claim 10,
wherein the housing (1) is manufactured with at least one fastening element, which is embodied in order to fasten the printed circuit board (51) to the housing (1).

12. Method according to one of the preceding claims,
wherein the leads (9) are produced in the form of a lead frame (5) with a lead holder (11), on which the leads (9) are arranged, and the lead holder (11) is separated and removed from the leads (9) after the leads (9) are injection moulded.

13. Housing (1), which is produced with a method according to one of the preceding claims.

14. Electronic module (3) with a housing (1), which is produced with a method according to one of claims 1 to 12.

## Revendications

1. Procédé de fabrication d'un boîtier (1) d'un module (3) électronique, dans lequel
- on surmoule de matière plastique, dans un outil (20) de moulage par injection, des leads (9), qui ont chacune une surface (13) de lead pouvant être reliée, dans lequel on produit, pour chaque lead (9), un évidement (7) de broche, qui s'étend à travers la matière plastique et qui comprend un évidement (17) de lead dans le lead (9), et dans lequel on n'injecte pas au moins une partie de chaque surface (13) de lead, qui peut être reliée, et
- dans au moins un évidement (7) de broche, on insère un élément (37) de broche conducteur de l'électricité, dans lequel on guide l'élément (37) de broche par l'évidement (17) de lead de l'évidement (7) de broche,
**caractérisé en ce que**
l'outil (20) de moulage par injection a, pour chaque évidement (7) de broche à produire, un composant (21) de poinçon et un composant (23) de matrice qui, à la fermeture de l'outil (20) de moulage par injection, ferme l'évidement (17) de lead de l'évidement (7) de broche sur des côtés opposés l'un à l'autre et, après la fermeture de l'outil (20) de moulage par injection, le surmoule de la matière plastique.

2. Procédé suivant la revendication 1,
dans lequel on relie à complémentarité de forme avec le lead (9) chaque élément (37) de broche, lors de l'insertion dans un évidement (7) de broche.

3. Procédé suivant la revendication 2,
dans lequel chaque élément (37) de broche a une partie (43) rétrécie, qui correspondant, en ce qui concerne sa section transversale et son étendue, à un évidement (17) de lead et auquel se raccorde, des deux côtés, respectivement une partie (45, 47) de butée de l'élément (37) de broche, dont la section transversale est plus grande que la section transversale d'un évidement (17) de lead, et dans lequel on ménage une liaison à complémentarité de forme d'un élément (37) de broche avec un lead (9), en poussant une première partie (45) de butée de l'élément (37) de broche dans l'évidement (17) de lead du lead (9) jusqu'à ce que la deuxième partie (47) de butée de l'élément (37) de broche bute sur le lead (9) .

4. Procédé suivant l'une des revendications précédentes,
dans lequel chaque élément (37) de broche a une partie (49) d'extrémité qui, par une surface de section transversale décroissante, s'éloigne de la première partie (45) de butée.

5. Procédé suivant l'une des revendications précédentes,
dans lequel on produit ou on agrandit les évidements (17) de lead à la fermeture de l'outil (20) de moulage par injection, en poussant les composants (21) de poinçon dans les leads (9).

6. Procédé suivant l'une des revendications précédentes,
dans lequel chaque composant (21) de poinçon a une extrémité (25) de poinçon se terminant en pointe, que l'on pousse dans un lead (9) pour la production ou l'agrandissement d'un évidement (17) de lead.

7. Procédé suivant l'une des revendications précédentes,
dans lequel chaque composant (23) de matrice a une extrémité (27) de matrice, qui a une cavité (29), qui est bordée par une paroi (31) annulaire qui, après la fermeture de l'outil (20) de moulage par injection, s'applique au lead (9) et ferme d'un côté l'évidement (17) de lead.

8. Procédé suivant l'une des revendications précédentes,
dans lequel chaque élément (37) de broche a au moins une partie (39) d'épaississement, qui a, par rapport aux parties qui en sont voisines de l'élément (37) de broche, un diamètre agrandi, qui correspond à un diamètre d'un évidement (7) de broche à l'extérieur de l'évidement (17) de lead.

9. Procédé suivant l'une des revendications précédentes,
**caractérisé en ce que** chaque élément (37) de broche est conformé de manière à ce qu'une extrémité (41) de mise en contact de l'élément (37) de broche fasse saillie de l'évidement (7) de broche après l'insertion dans un évidement (7) de broche.

10. Procédé suivant l'une des revendications précédentes,
dans lequel on monte, sur une plaquette (51) à circuit imprimé, des éléments (37) de broche avant l'insertion dans des évidements (7) de broche, et on les insère simultanément dans des évidements (7) de broche.

11. Procédé suivant la revendication 10,
dans lequel on fabrique le boîtier (1) avec au moins un élément de fixation, qui est constitué pour la fixation de la plaquette (51) à circuit imprimé sur le boîtier (1).

12. Procédé suivant l'une des revendications précédentes,
dans lequel on fabrique les leads (9) sous la forme d'un leadframe (5) ayant un support (11) de lead, sur lequel les leads (9) sont disposées et on sépare des leads (9) le support (11) de lead et on le retire, après le surmoulage des leads (9).

13. Boîtier (1), qui est fabriqué par un procédé suivant l'une des revendications précédentes.

14. Module (3) électronique ayant un boîtier (1), qui est fabriqué par un procédé suivant l'une des revendications 1 à 12.
